# EUROPÄISCHE PATENTSCHRIFT

(11) **EP 1 364 380 B1**
(45) Veröffentlichungstag und Bekanntmachung des Hinweises auf die Patenterteilung: **30.11.2005**
(21) Anmeldenummer: 02719866.2
(22) Anmeldetag: 19.02.2002
(51) Int. Cl.: H01H 19/58, G01D 3/08

(54) **ELEKTRISCHER SCHALTER**
ELECTRIC SWITCH
COMMUTATEUR ELECTRIQUE

(30) Priorität: 22.02.2001 DE 10108605
(43) Veröffentlichungstag der Anmeldung: 26.11.2003
(73) Patentinhaber: Leopold Kostal GmbH & Co. KG, 58507 Lüdenscheid (DE)
(72) Erfinder: DUNSCH, Martin, 58675 Hemer (DE); ADAM, Markus, 57462 Olpe (DE)
(86) Internationale Anmeldenummer: PCT/EP2002/001716
(87) Internationale Veröffentlichungsnummer: WO 2002/069362

(56) Entgegenhaltungen:
- US-A- 4 788 393
- US-A- 4 970 512

## Beschreibung

Die Erfindung betrifft einen elektrischen Schalter mit einer digitalen Schaltstellungserfassung umfassend ein Schaltmittel zum Kontaktieren von einzelnen Codespuren zugeordneten Schalterkontakten, wobei durch das Schaltmittel in unterschiedlichen Schaltstellungen in der Summe unterschiedliche Schalterkontakte kontaktiert sind und der Abgriff der durch das Schaltmittel kontaktierten Schalterkontakte eine Auswerteeinheit beaufschlagt.

Das Dokument US 4 970 512 offenbart einen Shalter nach dem Oberbegriff des Anspruchs 1.

Es sind elektrische Schalter bekannt, die in unterschiedliche Schaltstellungen gebracht werden können. Im Automotive-Bereich können derartige Schalter beispielsweise einem Gangwahlhebel oder auch einer Tempomateinrichtung zugeordnet sein. Diese Schalter umfassen als Schaltmittel zumeist einen Schleifer, der sich über mehrere Codespuren erstreckt. Die Codespuren tragen einzelne Schalterkontakte, wobei vorgesehen ist, daß in unterschiedlichen Stellungen des Schaltmittels und somit in unterschiedlichen Schalterstellungen in der Summe unterschiedliche Schalterkontakte der einzelnen Codespuren durch das Schaltmittel kontaktiert sind. Die einzelnen Schalterstellungen sind dadurch voneinander unterscheidbar, daß in Abhängigkeit von der Stellung des Schaltmittels ein Schalterkontakt kontaktiert oder nicht kontaktiert ist. Entsprechend erfolgt eine Auswertung eines solchen Schalterkontaktes als digitale "0" oder als digitale "1". Durch entsprechende Kombination der Kontaktierung der Schalterkontakte in einzelnen Codespuren sind die einzelnen Schalterstellungen des elektrischen Schalters dadurch voneinander unterscheidbar, daß jede Kombination zwischen kontaktierten und nicht kontaktierten Schalterkontakten nur einmal in den unterschiedlichen Schalterstellungen definiert ist.

Die einzelnen Schalterkontakte sind über jeweils eine Abgriffleitung mit einer Auswerteinheit verbunden, die für das Auslesen und Auswerten der Schalterkontakte in Abhängigkeit der Schaltstellungen zuständig ist. In Abhängigkeit von der erkannten Schalterstellung wird dann von der Prozessoreinheit ein entsprechendes Signal zum Ansteuern eines oder mehrerer Aktoren generiert.

Auch wenn ein solcher elektrischer Schalter grundsätzlich zufriedenstellend funktioniert und mit einfachen Mitteln herstellbar ist, können Probleme bezüglich einer eindeutigen Schaltstellungserkennung entstehen, wenn eine Kontaktierung eines Schalterkontaktes mit dem Schaltmittel nur unzureichend erfolgt, beispielsweise wenn die Kontaktstelle verschmutzt ist. In einem solchen Fall kann es vorkommen, daß aufgrund der schlechten Kontaktierung der Übergangswiderstand so groß ist, daß die auswerteseitig erfaßte Pegelspannung unterhalb des vorgegebenen Schwellwertes liegt und somit eine nicht korrekte Schaltstellungserfassung erfolgt, wobei das Ausleseergebnis als solches nicht als fehlerbehaftet erkennbar ist. Entsprechendes gilt ebenfalls bei einem Leitungsbruch.

Es besteht daher der Wunsch, einen elektrischen Schalter zur Hand zu haben, bei dem eine sichere Schaltstetlungserfassung, insbesondere auch hinsichtlich einer Fehlerdetektion möglich ist.

Daher ist es Aufgabe der vorliegenden Erfindung, einen eingangs genannten elektrischen Schalter dergestalt weiterzubilden, daß mit diesem eine sichere Schaltstellungserfassung einschließlich einer Fehlerdetektion möglich ist.

Diese Aufgabe wird erfindungsgemäß dadurch gelöst, daß in Abhängigkeit von der Stellung des Schaltmittels bei zumindest einigen Schaltstellungen die Pegelspannung zur zusätzlichen Unterscheidung dieser Schaltstellung einen unterschiedlichen Wert aufweist.
Bei dem erfindungsgemäßen elektrischen Schalter ist vorgesehen, daß die Pegelspannung in unterschiedlichen Schalterstellungen nicht gleichbleibend ist, sondern als zusätzliches Unterscheidungskriterium der unterschiedlichen Schalterstellungen dient. Der Vorteil einer solchen zusätzlichen Schalterstellungscodierung liegt darin, daß grundsätzlich jede Schalterstellung zunächst digital codiert ist. Durch die zusätzliche und grundsätzlich redundante Information ist eine Auswertung einer Schalterstellung hinsichtlich eines Vorliegens eines Fehlers möglich, da die Pegelspannung der kontaktierten Schalterkontakte in einer Schalterstellung analog bewertet wird und diese in jeder Schalterstellung unterschiedlich ist. Somit ist auf einfache Weise ein elektrischer Schalter geschaffen, dessen Schalterstellungen redundant durch eine digitale und analoge Codierung ausgewertet werden können. Durch die implementierte analoge Auswertung ist eine Fehlererkennung möglich.

Bei einem solchen elektrischen Schalter kann vorgesehen sein, daß durch die unterschiedlichen Pegelspannungen entweder die digitale "0" in einzelne Pegelspannungen, zweckmäßigerweise Pegelspannungsintervalle entsprechend der Anzahl der zu realisierenden Schalterstellungen unterteilt ist. Dann kann die digitale "1" bezüglich ihrer Pegelspannung konstant sein. Entsprechend kann ein solcher elektrischer Schalter auch umgekehrt oder aus einer Kombination aufgebaut sein.

Zur Bereitstellung unterschiedlicher Pegelspannungen in den unterschiedlichen Schalterstellungen ist in einer ersten Ausgestaltung der Erfindung vorgesehen, daß in die Pegelspur jeweils ein unterschiedlich codierter pull-down-Widerstand eingeschaltet ist. In einer zweiten Ausgestaltung ist vorgesehen, die Pegelspurleitung als kontinuierliche Potentiometerbahn auszuführen, die mit ihrem einen Ende mit dem Betriebsspannungspotential Vcc und mit ihrem anderen Ende mit dem Massepotential GND verbunden ist Eine solche Pegelspannungsbereitstellung ist auf besonders einfache Weise realisierbar. Die Abgriffe der einzelnen Schalterkontakte beaufschlagen einen A/D-Wandler, der eingangsseitig an eine Prozessoreinheit angeschlossen ist. Der Prozessoreinheit ist ein Speichermodul zugeordnet, in dem die die unterschiedlichen Schaltstellungen kennzeichnenden Pegelspannungen bzw. Pegelspannungsintervalle gespeichert sind.

Nachfolgend ist die Erfindung anhand von Ausführungsbeispielen unter Bezugnahme auf die beigefügten Figuren beschrieben.

Dabei zeigen
- **Fig. 1:**: nach Art eines Blockschaltbildes unterschiedliche Schaltstellungen eines erfindungsgemäßen elektrischen Schalters nach einer ersten Ausführungsform.
- **Fig. 2:**: eine zweite Ausführungsform des erfindungsgemäßen elektrischen Schalters mit einer Potentiometerbahn als Pegelspur

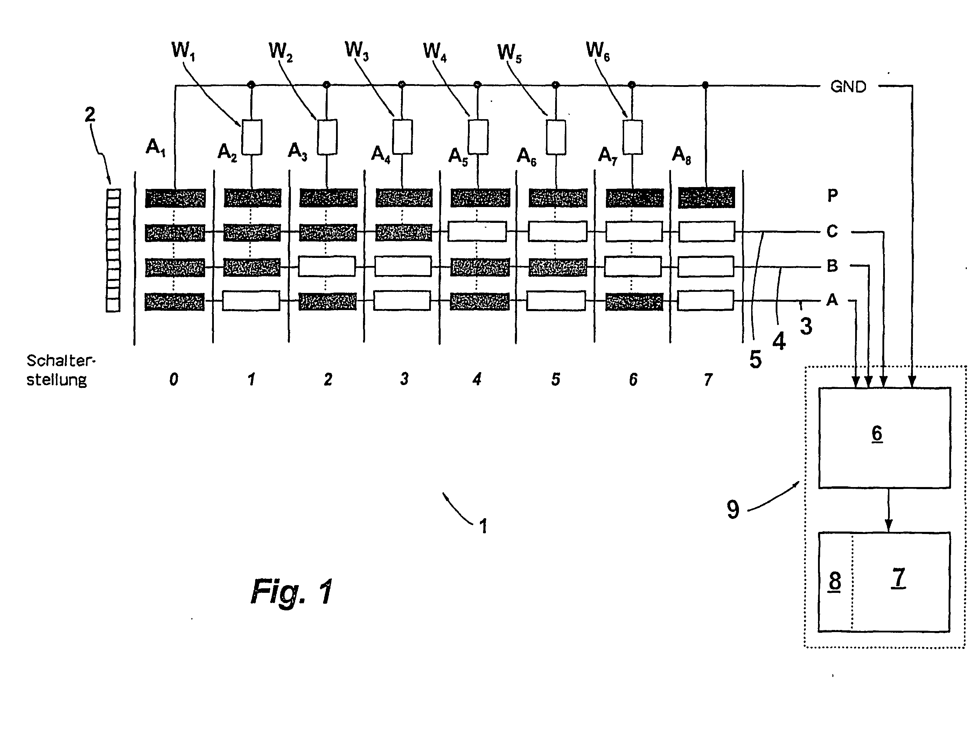

Wie aus Fig. 1 hervorgeht, umfaßt der elektrische Schalter 1 als Schaltmittel einen Schleifer 2, der mit seinen Kontakten auf drei digitalen Codespuren A, B, C mit elektrischen Schalterkontakten aufliegt und gegenüber diesen verschieblich ist. Der dargestellte Schalter ist theoretisch in acht unterschiedliche Schaltstellungen bringbar. Symbolisiert sind in der Figur mit schwarzen Kästchen diejenigen Schalterkontakte wiedergegeben, die von dem Schleifer 2 in einzelnen Schalterpositionen kontaktiert sind. Ein durch den Schleifer 2 nicht kontaktierter Schalterkontakt ist als nicht gefülltes Kästchen gekennzeichnet. In jeder Schalterstellung ist der Schleifer 2 mit einer Pegelspur P kontaktiert. Die digitale Codierung des elektrischen Schalters 1 ist dergestalt konzipiert, daß die gefüllten Kästchen eine digitale "0" und die nicht gefüllten Kästchen eine digitale "1" darstellen. Bei dem dargestellten elektrischen Schalter 1 ist daher die digitale "1" konstant und die digitale "0" als zusätzlich analog codierte Variable anzusehen. Tatsächlich genutzt werden bei dem elektrischen Schalter 1 lediglich die Schaltstellungen *1* bis *6*; eine Detektion etwa der nicht belegten Schalterstellung *7* als Ausleseergebnis einer der Schalterstellungen *1* bis *6* zeigt beispielsweise einen Leitungsbruch an.

Ausgehend von der Schalterstellung *0*, bei der der Schleifer 2 die Schalterkontakte von allen drei Codespuren A, B, C kontaktiert und diese somit sämtlich als digitale "0" auszulesen sind, so daß keine Pegelspannung detektierbar ist, erfolgt in den weiteren Schalterstellungen jeweils eine unterschiedliche Kontaktierung von in der Summe unterschiedlichen Schalterkontakten der digitalen Codespuren A, B, C.

In der Schalterstellung 7 werden keine Schalterkontakte der Codespuren A, B, C kontaktiert, so daß in dieser Stellung sämtliche Codespuren A, B, C als digitale "1" erkannt werden. In jeder Schalterstellung ist der Schleifer 2 bezüglich seiner Pegelspur P an einen unterschiedlichen Pegelspurast A₁ - A₈ angeschlossen. Die Schalterkontakte der Codespuren A, B, C sind jeweils über eine Abgriffleitung 3, 4, 5 an einen A/D-Wandler 6 angeschlossen, der ebenfalls durch eine GND-Leitung beaufschlagt ist, an die die Pegelspuräste A₁ - A₈ angeschlossen sind. In die Pegelspuräste A₁ - A₆ ist jeweils ein unterschiedlich pull-down-Widerstand W₁ - W₆ eingeschaltet, so daß die an den Abgriffleitungen 3, 4, 5 jeweils ausgelesene Pegelspannung in Abhängigkeit zu der Codierung des Widerstandes W₁ - W₆ einer Schalterstellung unterschiedlich ist. Die benötigten pull-up-Widerstände sind der nachgeschalteten Auswerteeinheit zugeordnet.

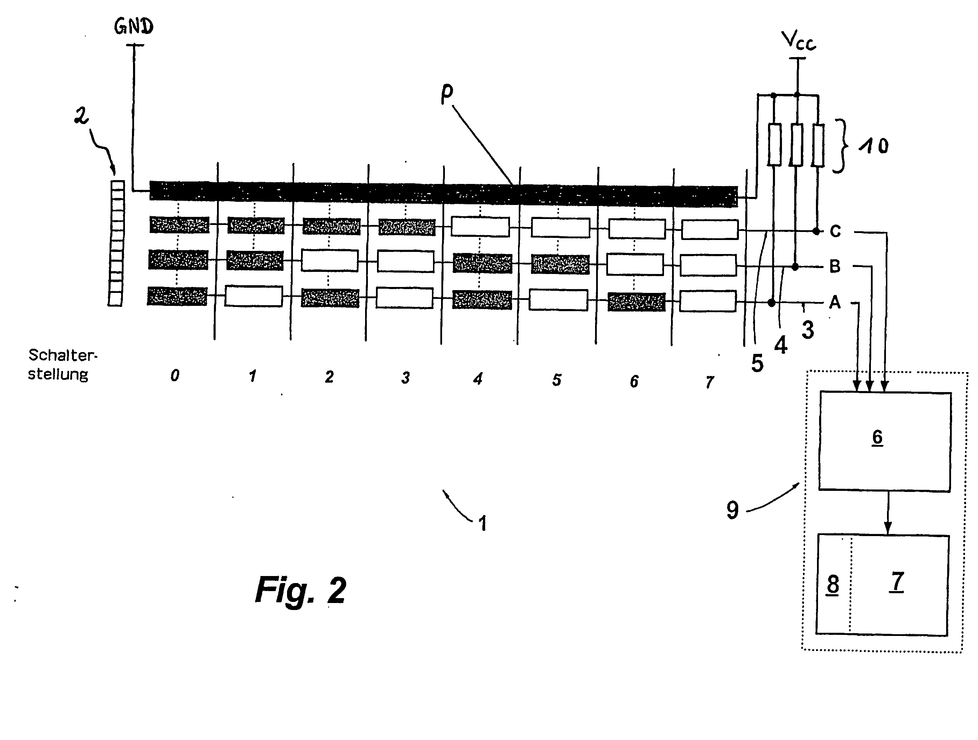

Auch bei der in Fig. 2 dargestellten Ausführungsform umfaßt der elektrische Schalter 1 als Schaltmittel einen Schleifer 2, der mit seinen Kontakten auf drei digitalen Codespuren A, B, C mit elektrischen Schalterkontakten sowie auf einer Pegelspur P aufliegt und in unterschiedliche Schaltstellungen bringbar ist. Die Symbolisierung der kontaktierten und nicht kontaktierten Schalterkontakte ist wie in Fig. 1 durch gefüllte und nicht gefüllte Kästchen wiedergegeben und die digitale Codierung des elektrischen Schalters 1 ist auch hier so konzipiert, daß die gefüllten Kästchen eine digitale "0" und die nicht gefüllten Kästchen eine digitale "1" darstellen. Der wesentliche Unterschied zu der Ausführungsform nach Fig. 1 besteht darin, daß hier als Pegelspur P eine durchgehende Potentiometerbahn eingesetzt ist, die mit ihrem einen Ende, welches sich nahe der Schaltstellung *0* befindet, mit dem Massepotential GND verbunden und mit ihrem anderen Ende, welches sich nahe der Schaltstellung *7* befindet, mit dem Betriebsspannungspotential Vcc verbunden ist. In jeder Zwischenstellung wird durch die Potentiometerbahn ein Potential zur Verfügung gestellt und durch den Schleifer 2 auf die jeweils kontaktierten Schalterkontakte der Codespuren A, B, C übertragen, welches zwischen diesen beiden Werten (hier z.B. 0 und 5 Volt) liegt, und dessen jeweiliger Wert sich aus dem Abstand des Abgriffpunktes von den Enden der Potentiometerbahn ergibt. Der zu einer Schaltstellung gehörige Spannungswert ist deshalb davon abhängig, wo der Schleifer auf dem Schalterkontakt aufliegt, was jedoch durch den ohnehin als Intervall vorgegebenen Pegelwert ohne weiteres zu erfassen ist. Durch pull-up-Widerstände 10 in den Abgriffleitungen 3, 4, 5 der Codespuren A, B, C ist sichergestellt, daß nicht kontaktierte Codespuren jeweils einen Pegel > 4,75 Volt aufweisen. Der mit dieser Ausführung verbundene Vorteil besteht insbesondere in der Einsparung der pull-down-Widerstände sowie in der Unabhängigkeit vom Übergangswiderstand des Schleifers.

Die nachfolgend wiedergegebene Tabelle zeigt Wertebereiche der ausgelesenen Pegelspannung zur Definition einer Schalterstellung bei einer Betriebsspannung von 5V:

| Schalterstellung | Kontakt A (digital) | Kontakt B (digital) | Kontakt C (digital) | Pegelbereich [V] |
|---|---|---|---|---|
| 0 | 0 | 0 | 0 | < 0,50 |
| 1 | 1 | 0 | 0 | 0,50-1,00 |
| 2 | 0 | 1 | 0 | 1,25-1,75 |
| 3 | 1 | 1 | 0 | 2,00-2,50 |
| 4 | 0 | 0 | 1 | 2,75-3,25 |
| 5 | 1 | 0 | 1 | 3,50-4,00 |
| 6 | 0 | 1 | 1 | 4,25-4,75 |
| 7 | 1 | 1 | 1 | > 4,75 |

Der A/D-Wandler 6 ist eingangsseitig an eine Prozessoreinheit 7 angeschlossen, der ein Speichermodul 8 zugeordnet ist, in dem die Pegelinter valle zum Kennzeichnen der unterschiedlichen Schalterstellungen hinterlegt sind. Auf diese Weise kann bei einer Auswertung der Schalterstellung neben dem digitalen Code eine Überprüfung des digitalen Schaltstellungserfassungsergebnisses anhand der erfaßten Pegelspannung erfolgen. Die Auswerteeinheit ist in der Figur insgesamt mit dem Bezugszeichen 9 gekennzeichnet.

Aus der Beschreibung der Erfindung wird deutlich, daß mit dem beschriebenen elektrischen Schalter unter Einsatz einfacher Mittel eine Schaltstellungserfassung in redundanter Art und Weise erfolgen kann und daß auf diese Weise insbesondere eine Fehlinterpretation einer Schalterstellung vermieden ist.

### Bezugszeichenliste

- 1: Elektrischer Schalter
- 2: Schleifer
- 3: Abgriffleitung
- 4: Abgriffleitung
- 5: Abgriffleitung
- 6: A/D-Wandler
- 7: Prozessoreinheit
- 8: Speichermodul
- 9: Auswerteeinheit
- 10: pull-up-Widerstände

- A₁-A₈: Pegelspurast
- A, B, C: Digitale Codespuren
- P: Pegelspur
- W₁-W₆: pull-down-Widerstand

## Patentansprüche

1. Elektrischer Schalter mit einer digitalen Schaltstellungserfassung, umfassend ein Schaltmittel (2) zum Kontaktieren von einzelnen Codespuren (A, B, C) zugeordneten Schalterkontakten, wobei durch das Schaltmittel in unterschiedlichen Schaltstellungen in der Summe unterschiedliche Schalterkontakte kontaktiert sind, und der Abgriff der durch das Schaltmittel (2) kontaktierten Schalterkontakte eine Auswerteeinheit (9) beaufschlagt, **dadurch gekennzeichnet, daß** in Abhängigkeit von der Stellung des Schaltmittels (2) bei zumindest einigen Schaltstellungen die Pegelspannung zur zusätzlichen Unterscheidung dieser Schaltstellung einen unterschiedlichen Wert aufweist.

2. Schalter nach Anspruch 1, **dadurch gekennzeichnet, daß** zur Bereitstellung unterschiedlicher Pegelspannungen in eine Pegelspurleitung (A2 - A6) jeweils ein unterschiedlich codierter pull-down-Widerstand (W2 - W6) eingeschaltet ist und die zugeordneten pull-up-Widerstände in einer Auswerteeinheit integriert sind.

3. Schalter nach Anspruch 1, **dadurch gekennzeichnet, daß** zur Bereitstellung unterschiedlicher Pegelspannungen eine durchgehende Potentiometerbahn als Pegelspur P eingesetzt ist, die mit ihrem einen Ende mit dem Massepotential GND und mit ihrem anderen Ende mit dem Betriebsspannungspotential Vcc verbunden ist.

4. Schalter nach einem der Ansprüche 1 bis 3, **dadurch gekennzeichnet, daß** Abgriffleitungen (3, 4, 5) der einzelnen Schalterkontakte einen A/D-Wandler (6) beaufschlagen, der eingangsseitig an eine ein Speichermodul (8) umfassende Prozessoreinheit (7) angeschlossen ist, wobei in dem Speichermodul (8) die unterschiedliche Schaltstellungen kennzeichnenden Pegelspannungen in Form von Pegelspannungsintervallen gespeichert sind.

5. Schalter nach einem der Ansprüche 1 bis 4, **dadurch gekennzeichnet, daß** der Schalter n Schaltstellungen aufweist und n-1 Schaltstellungen durch jeweils unterschiedliche Pegelspannungen **gekennzeichnet** sind, die jeweils geringer sind als die maximale Pegelspannung.

6. Schalter nach einem der Ansprüche 1 bis 5, **dadurch gekennzeichnet, daß** die digitale "0" zusätzlich analog durch unterschiedliche Pegelspannungen in unterschiedlichen Schalterstellungen codiert ist.

7. Schalter nach einem der Ansprüche 1 bis 6, **dadurch gekennzeichnet, daß** die digitale "1" zusätzlich analog durch unterschiedliche Pegelspannungen in unterschiedlichen Schalterstellungen codiert ist.

## Claims

1. Electrical switch with a digital switch position detection comprising switching means (2) for contacting switching contacts assigned to individual code tracks (A, B, C), with various switching contacts being contacted altogether in different switch positions by the switching means, and with the tapping of the switching contacts contacted by the switching means (2) admitted to an analysing unit (9), **characterised by** the fact that for at least some switch positions the gauge voltage shows a different value as an additional differentiation of this switch position, depending on the position of the switching means (2).

2. Switch in accordance with Claim 1, **characterised by** the fact that a differently coded pull-down resistor (W2 - W6) is brought into circuit in each gauge track line (A2 - A6) for providing different gauge voltages, and the assigned pull-up resistors are integrated in an analysing unit.

3. Switch in accordance with Claim 1, **characterised by** the fact that in order to provide various gauge voltages a continuous potentiometric path is employed as a gauge track P whose one end is connected to the frame potential GND and whose other end is connected to the operating voltage potential Vcc.

4. Switch in accordance with any of Claims 1 to 3, **characterised by** the fact that tapping lines (3, 4, 5) of the individual switching contacts are admitted to an A/D converter (6) that is connected at the input side to a processor unit (7) comprising a memory sub-module, with the gauge voltages that identify the various switch positions being stored in the memory sub-module (8) in the form of gauge voltage intervals.

5. Switch in accordance with any of Claims 1 to 4, **characterised by** the fact that the switch shows n switch positions and n-1 switch positions are identified by various gauge voltages, respectively, each of which is less than the maximum gauge voltage.

6. Switch in accordance with any of Claims 1 to 5, **characterised by** the fact that the digital "0" is additionally analogue coded by means of various gauge voltages at various switch positions.

7. Switch in accordance with any of Claims 1 to 6, **characterised by** the fact that the digital "1" is additionally analogue coded as a result of various gauge voltages at various switch positions.

## Revendications

1. Commutateur électrique avec un captage numérique de la position de commutation, comprenant une moyen de commutation (2) pour la mise en contact des contacts de commutateurs associés à des pistes de codes individuelles (A, B, C), des contacts de commutateurs de nombre différents étant mis en contact par le moyen de commutation dans des positions de commutation différentes, et les prises des contacts de commutateurs contactés par le moyen de commutation (2) agissant sur une unité d'évaluation, **caractérisé en ce que**, en dépendance de la position du moyen de commutation (2), dans au moins quelques-unes des positions de commutation, la niveau-tension présente une valeur différente pour différencier de manière supplémentaire cette position de commutation.

2. Commutateur selon la revendication 1, **caractérisé en ce que**, pour la mise à disposition de différentes tensions de niveau dans une ligne de piste niveau (A2-A6), une résistance pull-down (W2-W6) différemment codée est chaque fois connectée et que les résistances pull-up associées sont intégrées dans une unité d'évaluation.

3. Commutateur selon la revendication 1, **caractérisé en ce que**, pour la mise à disposition de différentes tensions de niveau, une piste de potentiomètre continue est mise en oeuvre en tant que piste niveau P, laquelle est reliée au potentiel de masse GND, par l'une de ses extrémités, et au potentiel de tension de service Vcc, par son autre extrémité.

4. Commutateur selon l'une des revendications 1 à 3, **caractérisé en ce que** des lignes de prise intermédiaires (3, 4, 5) des différents contacts de commutateurs agissent sur un convertisseur A/D (6) qui est raccordé, côté entrée, à une unité centrale (7) qui comprenant un module de mémoire (8), les niveau-tensions, qui **caractérisent** les positions de commutation différentes, étant mémorisées dans ledit module de mémoire (8), sous la forme d'intervalles de niveau-tension.

5. Commutateur selon l'une des revendications 1 à 4, **caractérisé en ce que** le commutateur présente n positions de commutation, et que n-1 positions de commutation sont **caractérisées** chacune par des niveau-tensions différentes, qui sont chacune plus faibles que la niveau-tension maximum.

6. Commutateur selon l'une des revendications 1 à 5, **caractérisé en ce que** le "0" numérique est supplémentairement codé analogiquement, dans différentes positions de commutateurs, par des niveau-tensions différentes.

7. Commutateur selon l'une des revendications 1 à 6, **caractérisé en ce que** le "1" numérique est codé en plus de manière analogique dans différentes positions de commutateur par des niveau-tensions différentes.
